## Europäisches Patentamt
## European Patent Office
## Office européen des brevets

(19)

(11) Veröffentlichungsnummer: **0 071 978**
A2

(12) # EUROPÄISCHE PATENTANMELDUNG

(21) Anmeldenummer: 82107052.1

(22) Anmeldetag: 04.08.82

(51) Int. Cl.³: **H 03 K 3/70**, H 03 K 3/017

(30) Priorität: 07.08.81 DE 3131362

(43) Veröffentlichungstag der Anmeldung: 16.02.83
Patentblatt 83/7

(84) Benannte Vertragsstaaten: **AT FR GB IT NL**

(71) Anmelder: **SIEMENS AKTIENGESELLSCHAFT, Berlin und München Wittelsbacherplatz 2, D-8000 München 2 (DE)**

(72) Erfinder: **Urbigkeit, Frank, Ing, grad., Lechstrasse 9, D-8014 Neubiberg (DE)**

(54) **Taktgenerator für Start-Stop-Betrieb.**

(57) Die Erfindung betrifft einen Taktgenerator für Start-Stop-Betrieb mit wählbarem Impuls-Pausenverhältnis. Das Grundelement des Taktgenerators ist ein bandfiltergekoppelter Oszillator mit zwei invertierenden Verknüpfungsgliedern, der zur Erhöhung der Frequenzkonstanz durch einen Quarzoszillator synchronisiert wird. Zur Verbesserung der Konstanz der Impulslängen von Taktimpulsen, die kürzer als eine halbe Taktperiode sind, ist ein zusätzlicher quarzgesteuerter Führungsoszillator vorgesehen.

SIEMENS AKTIENGESELLSCHAFT
BERLIN UND MÜNCHEN

Unser Zeichen
VPA
81 P 2070 E

0071978

Taktgenerator für Start-Stop-Betrieb

In Datenverarbeitungsanlagen werden zur Erzeugung von Systemtakten mit einer Mehrzahl von gegeneinander phasenverschobenen Taktsignalen Taktgeneratoren hoher Frequenzkonstanz benötigt, die durch ein asynchrones Signal angehalten und wieder gestartet werden können. Hierzu kommen im Prinzip Laufzeitoszillatoren oder RC-Oszillatoren in Betracht. Da bei solchen Oszillatoren die temperaturabhängige Phasendrehung der aktiven Verstärkerstufe eine wichtige Rolle spielt, ist ein erheblicher Aufwand erforderlich, um diese Temperaturabhängigkeit zu kompensieren. An sich hochkonstante Quarzoszillatoren lassen sich wegen ihres schlechten Einschwingverhaltens für einen Start-Stop-Betrieb nicht verwenden.

Bei der Taktsteuerung digitaler Schaltnetze tritt häufig der Fall ein, daß ein Teil der Schaltglieder durch die ansteigenden Flanken der Taktimpulse, ein anderer Teil durch deren abfallende Flanken geschaltet wird. Ferner besteht die Möglichkeit, während der Dauer der Taktimpulse Signale abzutasten bzw. auszublenden.

Der Erfindung liegt die Aufgabe zugrunde, einen Taktgenerator für Start-Stop-Betrieb mit hoher Frequenzkonstanz anzugeben, der Taktimpulse mit in Grenzen wählbarem Impuls-Pausen-Verhältnis gleichfalls hoher Konstanz abgibt.

Gemäß der Erfindung wird diese Aufgabe, ausgehend von einer durch die DE-PS 22 45 476 bekannten Oszillatorschaltung, durch die Merkmale im kennzeichnenden Teil

Sh 1 Stl / 22.07.81

0071978

des Patentanspruchs 1 gelöst. Weiterbildungen der Erfindung sind den Unteransprüchen zu entnehmen. Im folgenden wird die Erfindung anhand von Ausführungsbeispielen unter Zuhilfenahme der Zeichnung näher beschrieben. Es zeigt

FIG 1     ein Prinzipschaltbild des erfindungsgemäßen Taktgenerators,

FIG 2     ein Impulsdiagramm für den Taktgenerator nach FIG 1,

FIG 3     einen Taktgenerator mit erhöhter Konstanz des gewählten Impuls-Pausen-Verhältnisses des Taktpulses,

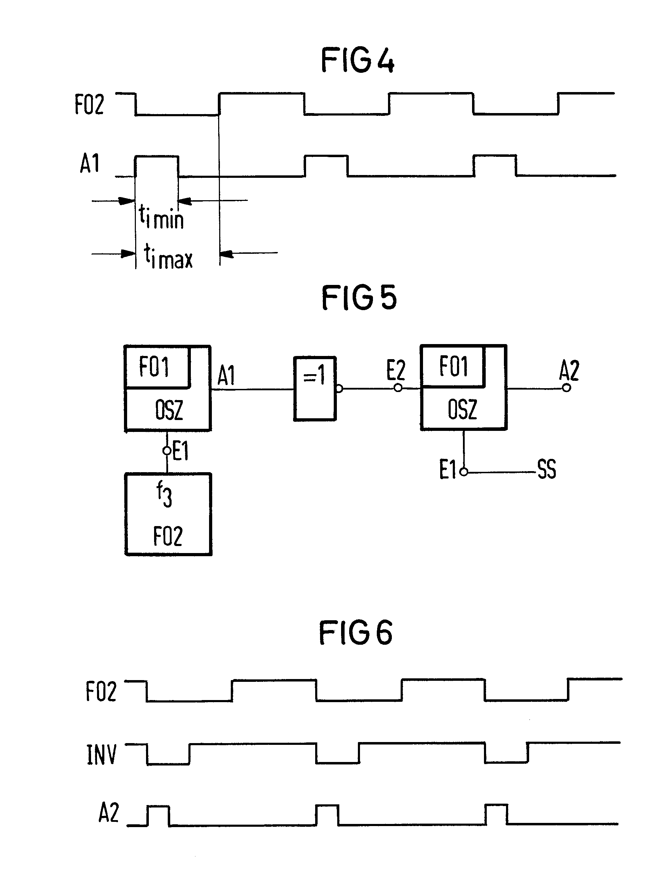

FIG 4     ein Impulsdiagramm für das Ausführungsbeispiel nach FIG 3,

FIG 5     einen Taktgenerator für verkürzte Ausgangsimpulse,

FIG 6     ein Impulsdiagramm für das Ausführungsbeispiel nach FIG 5.

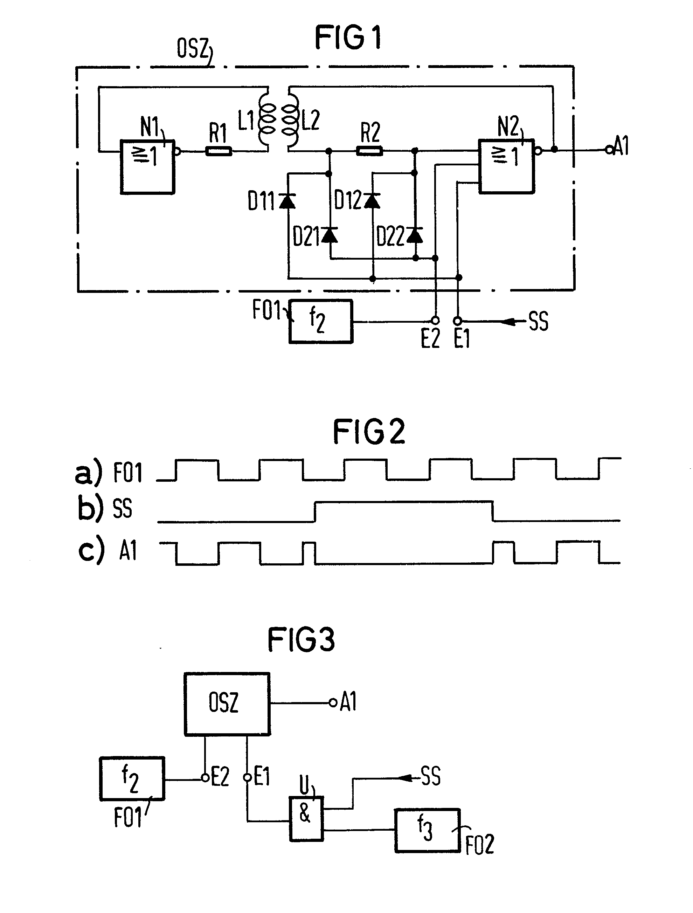

Die FIG 1 zeigt schematisch eine Oszillatorschaltung OSZ mit den beiden NOR-Gliedern N1 und N2, die jeweils in sich über die Widerstände R1 bzw. R2 und die Induktivitäten L1 bzw. L2 rückgekoppelt sind. Die Induktivitäten L1 und L2 bilden in Verbindung mit den nicht dargestellten Eingangs- und Ausgangskapazitäten der NOR-Glieder N1 und N2 Schwingkreise, die wegen der Kopplung der Induktivitäten L1 und L2 gleichfalls miteinander gekoppelt sind. Damit gibt die Oszillatorschaltung OSZ insgesamt, unabhängig von eventuellen Streuungen der Einzelkreise, (Rechteck-) Schwingungen mit einer definierten Frequenz ab. Einzelheiten sind der schon genannten DE-PS 22 45 476 zu entnehmen.

Das NOR-Glied N2 besitzt außer dem Rückkopplungseingang noch zwei weitere Eingänge, die mit Anschlußpunkten E1 und E2, im folgenden als Steuereingänge bezeichnet, verbunden sind. Die Steuereingänge sind ferner über Dioden D11 und D12 bzw. D21 und D22 mit den beiden Enden des Widerstands R2 verbunden.

Durch ein an dem Steuereingang E1 anliegendes Start-Stop-Signal SS kann die Oszillatorschwingung gestartet oder angehalten werden. Für viele Fälle wird die Konstanz der Eigenschwingungsfrequenz $f_1$, d.h. die Frequenzkonstanz der Taktimpulse nicht ausreichend sein. Eine diesbezügliche Verbesserung ergibt sich durch die Verbindung des zweiten Steuereingangs E2 mit dem Ausgang eines Quarzoszillators FO1 mit der Schwingungsfrequenz $f_2$ und einem Impuls-Pausen-Verhältnis von vorzugsweise 1 : 1. Sofern die Bedingung $f_1 < 2f_2 < 4f_1$ erfüllt ist, gibt der Taktgenerator am Ausgang A1 Taktimpulse mit der Frequenz $f_2$ ab. Die Frequenzkonstanz hängt nur noch von der Konstanz des Synchronisieroszillators FO1 ab.

Die FIG 2 zeigt Impulsdiagramme mit
a) dem Verlauf der Impulse am Ausgang des Synchronisieroszillators FO1,
b) dem Verlauf des Start-Stop-Signals SS und
c) den Taktimpulsverlauf am Ausgang A1.

Das Impuls-Pausenverhältnis der Taktimpulse am Ausgang A1 kann durch Wahl der Eigenschwingungsfrequenz $f_1$ des Start-Stop-Oszillators zwischen 1 : 1 und etwa 3 : 1

0071978

eingestellt werden. Da aber die Konstanz der Eigenschwingungsfrequenz $f_1$ nicht hoch angesetzt werden kann, ist die Impulsdauer gleichfalls wenig konstant. Aus dem gleichen Grund empfiehlt es sich, nicht ganz bis zum Grenzwert 3 : 1 für das Impuls-Pausenverhältnis heranzugehen.

Wie aus FIG 2 ersichtlich ist, kann der letzte und/oder der erste Impuls einer Impulsreihe verkürzt sein. Dies läßt sich durch eine Synchronisierung des Start-Stop-Signals SS vermeiden. Hierzu wird das Start-Stop-Signal SS dem Dateneingang eines durch die Ausgangsimpulse des Synchronisieroszillators F01 getakteten D-Flipflops zugeführt. Der Ausgang des D-Flipflops ist mit dem ersten Steuereingang E1 des Taktgenerators verbunden.

Eine erhebliche Verbesserung der Konstanz der Impulsdauer gelingt mit einer Schaltungsanordnung nach FIG 3. Die Schaltungseinheit TG entspricht mit Ausnahme einer geänderten Belegung des Steuereingangs E1 der Schaltungsanordnung nach FIG 1, d.h. sie enthält einen Start-Stop-Oszillator und einen Synchronisieroszillator F01. Der Steuereingang E1 ist dem Ausgang eines UND-Gliedes U verbunden, an dessen erstem Eingang nunmehr das Start-Stop-Signal SS anliegt. Der zweite Eingang des UND-Gliedes U ist mit dem Ausgang eines vorzugsweise quarzstabilisierten Führungsoszillators F02 verbunden, der eine Rechteckschwingung mit dem Impuls-Pausenverhältnis 1 : 1 und mit der Frequenz $f_3$ abgibt.

Die Taktfrequenz des Taktgenerators in der gemäß FIG 3 erweiterten Ausführungsform ist gleich der Frequenz $f_3$ des Führungsoszillators F02. Das Impuls-Pausenverhältnis hängt von dem Verhältnis dieser Frequenz $f_3$ zu der Frequenz $f_2$ des Synchronisieroszillators F01 ab und läßt sich zwischen 1 : 1 und 1 : 3 einstellen. Die

0071978

minimale Impulsdauer beträgt

$$t_{imin} = \frac{1}{4f_3}$$

die maximale Impulsdauer

$$t_{imax} = \frac{1}{2f_3}$$

Daraus ergibt sich die Beziehung $f_3 < f_2 < 2f_3$.

Eine weitere Verringerung der minimalen Impulsdauer ist mit einer in FIG 5 dargestellten Schaltungsanordnung zu erreichen  Hier ist an den Ausgang eines Taktgenerators mit Führungsoszillators FO2  der Start-Stop-Eingang eines weiteren Taktgenerators ohne Führungsoszillator angeschlossen. Die Steuerung des zweiten Taktgenerators, der auf eine Frequenz $f_4$  synchronisiert ist, erfolgt durch die invertierten Ausgangssignale des ersten Taktgenerators. Das ist in FIG 5  durch den zwischengeschalteten Inverter INV  zum Ausdruck gebracht. Mit $f_4 < 4f_3$  als Grenzwert  ergibt sich ein Impuls-Pausenverhältnis  von 1 : 7.

Eine weitere Verkleinerung des Impuls-Pausenverhältnisses der Ausgangsimpulse am Ausgang A2  ist dann möglich, wenn die Impuls-Pausenverhältnisse der Ausgangssignale der beiden Hilfsoszillatoren FO1  und FO2  größer als 1, z.B. 1,5 : 1  bis 2 : 1, werden. Eine solche Maßnahme verringert jedoch die Konstanz der Impulsdauer.

6  Figuren

5  Patentansprüche

0071978

Patentansprüche

1. Taktgenerator für Start-Stop-Prinzip mit einer zwei invertierende Verknüpfungsglieder enthaltenden Oszillatorschaltung mit der Eigenschwingungsfrequenz $f_1$, wobei jedes Verknüpfungsglied über ein phasendrehendes, mindestens eine Resonanzstelle aufweisendes Rückkopplungsnetzwerk und einem Widerstand in sich rückgekoppelt ist, die so gebildeten Einzeloszillatoren durch ein Bandfilter gekoppelt sind und das Ausgangssignal am Ausgang des einen invertierenden Verknüpfungsgliedes abnehmbar ist, d a d u r c h g e k e n n z e i c h n e t ,

a) daß ein erster (E1) und zweiter (E2) Steuereingang jeweils mit einem weiteren Eingang des das Ausgangssignal abgebenden Verknüpfungsgliedes (N2) sowie über Dioden (D11, D12 bzw. D21, D22) mit beiden Seiten des im Rückkopplungszweig liegenden Widerstands (R2) verbunden ist, wobei das Verknüpfungsglied (N2) als NOR-Glied ausgebildet ist,

b) daß der erste Steuereingang (E1) den Start-Stop-Eingang bildet,

c) daß an dem zweiten Steuereingang (E2) ein Synchronisieroszillator (FO1) mit der Schwingungsfrequenz $f_2$ angeschlossen ist und

d) daß zwischen der unbeeinflußten Eigenschwingungsfrequenz $f_1$ der Oszillatorschaltung und der Schwingungsfrequenz $f_2$ des Synchronisieroszillators (FO1) folgende Beziehung gilt:

$$f_1 \lesssim 2f_2 < 4f_1$$

2. Taktgenerator nach Anspruch 1, d a d u r c h g e - k e n n z e i c h n e t , daß an dem ersten Steuereingang (E1) ein Start-Stop-Signal (SS) anliegt.

0071978
81 P 2070 E

3. Taktgenerator nach Anspruch 1, d a d u r c h g e - k e n n z e i c h n e t , daß ein D-Flipflop (FF) vorgesehen ist, dessen Takteingang mit dem Ausgang des Synchronisieroszillators (FO1) verbunden ist, an des- sen Informationseingang (D) ein Start-Stop-Signal (SS) anliegt und dessen Ausgang (Q) mit dem ersten Steuereingang (E1) verbunden ist.

4. Taktgenerator nach Anspruch 1, d a d u r c h g e - k e n n z e i c h n e t , daß dem ersten Steuereingang (E1) ein UND-Glied (U) vorgeschaltet ist, an dessen einem Eingang ein Start-Stop-Signal (SS) anliegt und dessen zweiter Eingang mit dem Ausgang eines Führungsoszilla- tors (FO2) zur Erzeugung einer Rechteckschwingung mit der Frequenz $f_3$ und einem Impuls-Pausenverhältnis 1 : 1 verbunden ist, und daß für das Verhältnis der Schwingungs- frequenz $f_2$ des Synchronisieroszillators (FO1) und der Schwingungsfrequenz $f_3$ des Führungsoszillators (FO2) gilt:

$$f_3 < f_2 < 2f_3$$

5. Taktgenerator nach Anspruch 4, d a d u r c h g e - k e n n z e i c h n e t , daß mit dem Ausgang (A1) eines ersten Taktgenerators mit Führungsoszillator (FO2) über einen Inverter (INV) der erste Steuereingang (E1) eines zweiten Taktgenerators ohne Führungsoszillator verbunden ist

## FIG 1

OSZ

N1 R1 L1 L2 R2 N2 A1
≧ 1 ≧ 1

D11 D12

D21 D22

F01 f2

E2 E1 SS

## FIG 2

a) F01

b) SS

c) A1

## FIG 3

OSZ A1

f2 E2 E1 U
& SS

F01 f3 F02

## FIG 4

## FIG 5

## FIG 6